## Europäisches Patentamt

## European Patent Office

## Office européen des brevets

(19)

(11) Veröffentlichungsnummer : **0 361 171 B1**

(12)
# EUROPÄISCHE PATENTSCHRIFT

(45) Veröffentlichungstag der Patentschrift :
05.06.91 Patentblatt 91/23

(51) Int. Cl.⁵ : **C23C 16/44, C23C 16/40**

(21) Anmeldenummer : 89116613.4

(22) Anmeldetag : 08.09.89

(54) **Verfahren und Vorrichtung zum Verdampfen von bei Raumtemperatur flüssigen Monomeren.**

(30) Priorität : 30.09.88 DE 3833232

(43) Veröffentlichungstag der Anmeldung :
04.04.90 Patentblatt 90/14

(45) Bekanntmachung des Hinweises auf die
Patenterteilung :
05.06.91 Patentblatt 91/23

(84) Benannte Vertragsstaaten :
CH DE FR GB IT LI NL

(56) Entgegenhaltungen :
EP-A- 0 239 664
GB-A- 827 575
PATENT ABSTRACTS OF JAPAN, Band 12, Nr.
237 (C-509)[3084], 6. Juli 1988; & JP-A-63 28
439 (NIPPON KOKAN K.K.) 06-02-1988

(73) Patentinhaber : LEYBOLD
AKTIENGESELLSCHAFT
Wilhelm-Rohn-Strasse 25
W-6450 Hanau am Main 1 (DE)

(72) Erfinder : Hussla, Ingo, Dr.-Ing.
Feldstrasse 24
W-6450 Hanau am Main 8 (DE)
Erfinder : Ritter, Jochen, Dipl.-Ing.
Grünes Meer 16
W-6312 Laubach 4 (DE)

(74) Vertreter : Zapfe, Hans, Dipl.-Ing.
Am Eichwald 7, Postfach 20 01 51
W-6056 Heusenstamm 2 (Rembrücken) (DE)

**Beschreibung**

Die Erfindung betrifft ein Verfahren zum Verdampfen von bei Raumtemperatur flüssigen, einen niedrigen Dampfdruck aufweisenden Monomeren, insbesonderen solchen aus der Gruppe TEOS (Tetraethylorthosilikat), TMS (Tetramethylsilan) und HMDS (Hexamethyldisiloxan), bei der Herstellung von Silizium und Sauerstoff enthaltenden dünnen Schichten durch chemische Dampfabscheidung (CVD-Verfahren) im Vakuum auf Substraten unter Verwendung einer Strömungs-Stelleinrichtung und eines ihr nachgeschalteten Verdampfers.

Bei der Herstellung von Silizium und Sauerstoff enthaltenden Schichten werden Plasma-Verfahren und Dampfphasen-Abscheidungen bei vermindertem Druck (Vakuum) eingesetzt. Als Ausgangsmonomere kommen Flüssigkeiten wie TEOS, TMS und HMDS zum Einsatz, die sich durch einen verhältnismäßig niedrigen Dampfdruck bei Raumtemperatur auszeichnen. Wegen der geforderten extrem hohen Reinheit dieser Verbindungen kommt es beim Verdampfen häufig zu einem sogenannten Siedeverzug, d.h. zu einem stoßweisen, explosionsartigen Verdampfen größerer Flüssigkeitsmengen, und damit zu einem unregelmäßigen Massenstrom. Ganz besonders ausgeprägt ist diese Eigenschaft bei TEOS.

Durch den Aufsatz von B.L. Chin und E.P. van de Ven "Plasma TEOS Process for Interlayer Dielectric Applications" veröffentlicht in "Solid State Technology", April 1988, Seiten 119 bis 122, ist es bekannt, TEOS als Flüssigkeit in den Vakuum-Reaktor zu pumpem, wo es verdampft, und mit Hilfsgasen gemischt wird. Trotz einer computergesteuerten Flüssigkeitspumpe mit einem reproduzierbaren Durchsatz ist es wegen der stoßweisen Verdampfung der Flüssigkeit im Vakuum nicht möglich, einen ausreichend konstanten Massenstrom zu erzeugen.

Bei dieser Überlegung muß man sich vor Augen halten, daß sich jede Unregelmäßigkeit im Massenstrom in inhomogenen Schichteigenschaften äußert und – falls es sich um ein reaktives Verfahren handelt – auch um Abweichungen in der Stöchiometrie der Schichtzusammensetzung.

Durch den Aufsatz von S.P. Mukherjee und P.E. Evans "The Deposition of thin films by the decomposition of Tetra-Ethoxy silan in a radio frequency glow discharge" veröffentlich in "Thin Solid Films", 1972, Seiten 105-118, ist es bekannt, TEOS durch einen temperaturgeregelten Verdampfer zu Verdampfen, der eine definierte Dampfdruckerhöhung ermöglicht. Auch hierbei läßt sich eine kontinuierliche Verdampfung praktisch nicht erreichen. Falls andere Monomere verdampft werden sollen, muß die Vorrichtung sorgfältig an die Dampfdruckkurven dieser Monomeren angepaßt werden. Weiterhin ist das betreffende Verfahren in der Anwendung begrenzt, da kein beliebig hoher Dampfdruck erzeugt werden kann und die leicht kondensierbaren Dämpfe nur ungenügend zu transportieren und zu dosieren sind.

U. Mackens und U. Merkt beschreiben in dem Aufsatz "PlASMA-ENHANCED CHEMICALLY VAPOUR-DEPOSITED SILICON DIOXIDE FOR METAL/OXIDE/SEMICONDUCTOR STRUCTURES ON InSb", veröffentlicht in "Thin Solid Films", 1982, Seiten 53-61, ein ganz ähnliches Verfahren mit vergleichbaren Nachteilen.

Durch den Aufsatz von R.E. Howard "Selecting Semiconductor Dopants for Precise Process Control, Product Quality and Yield and Safety", veröffentlicht in "Microelectronic Manufacturing and Testing", Dezember 1985, Seiten 20-24, ist es weiterhin bekannt, ein in einem Quarzgefäß enthaltenes flüssiges Monomeres mit einem Edelgas (Argon, Helium) zu durchspülen, wobei das Edelgas die Monomeren mitreißt. Nachteilig ist bei diesem Verfahren die fehlende Information über die Mengen des tatsächlich in die Reaktionskammern gelangenden Monomeren. Hinzu kommt, daß stets Zusatzgase eingebracht werden müssen, so daß eine für viele Anwendungsfälle untragbare Begrenzung hinsichtlich der Wahl der Betriebsparameter Druck und Gasmenge die Folge ist.

Schließlich ist durch die EP-OS 0 239 664 ein Verfahren der eingangs beschriebenen Gattung bekannt, bei dem als Strömungs-Stelleinrichtung ein Nadelventil verwendet wird, dem ein nicht näher beschriebener Verdampfer nachgeschaltet ist. Eine solche Anordnung führt dazu, daß das Monomer hinter dem eine Drosselstelle bildenden Nadelventil mehr oder weniger unkontrolliert verdampft. Der Verdampfer dient alsdann nur noch dazu, etwa mitgerissene Flüssigskeitstropfen zu verdampfen und damit die vollständige Verdampfung sicherzustellen. Ein konstanter Massestrom ist infolgedessen auch mit diesem bekannten Verfahren nicht zu erreichen.

Der Erfindung liegt daher die Aufgabe zugrunde, ein Verfahren der eingangs beschriebenen Gattung anzugeben, bei dem eine konstante, genau einstellbare Dampfströmung bzw. Dampfmenge auch über einen langen Zeitraum aufrechterhalten werden kann.

Die Lösung der gestellten Aufgabe erfolgt bei dem eingangs beschriebenen Verfahren erfindungsgemäß dadurch, daß man als Strömungs-Stelleinrichtung einen Massendurchflußregler verwendet und das von diesem geförderte Monomer in flüssigem Zustand dem Verdampfer zuführt, in dem die restlose Verdampfung beim Druck des Vakuums in einem beheizten, eine Kapillarwirkung aufweisenden Körper herbeigeführt wird.

Bei einem solchem Verfahren erfolgt die Verdampfung nicht an einer unkontrollierbaren Stelle hinter der Strömungs-Stelleinrichtung, sondern ausschließlich und dann auch restlos im Verdampfer. Der Massendurchflußregler selbst sorgt für einen in äußerst engen Grenzen einregelbaren Nachschub an flüssigem Monomer. Mit anderen Worten : Es erfolgt eine außerordentlich gezielte und genaue Förderung von flüssigen Monomeren einerseits und eine sehr exakte Verdampfung an einem dafür vorgesehenen und ausgelegten Ort, nämlich innerhalb des Verdampfers bzw. innerhalb des beheizten, eine Kapillarwirkung aufweisenden Körpers andererseits.

Durch ihr Zusammenwirken führen diese beiden Maßnahmen auch zu dem gewünschten Erfolg. Auf ein Trägergas kann dabei vollständig verzichtet werden.

Bei dem erfindungsgemäß verwendeten Massendurchflußregler handelt es sich um ein Präzisionsgerät, bei dem ein Sollwert für den Durchsatz, d.h. die Strömungsmenge pro Zeiteinheit, vorgegeben und der Istwert auf eine möglichst geringe Abweichung vom Sollwert eingeregelt wird.

Ein für diesen Zweck hervorragend geeigneter Massendurchflußregler wird von der Firma Bronkkorst High-Tech B.V. in Ruurlo/Holland unter der Typenbezeichnung F 902-FA angeboten. Das Meßprinzip für den Istwert des Massenstroms beruht auf -einer laminaren Strömung in einer beheizten Leitung unter Zufuhr einer konstanten elektrischen Leistung. Aus der Messung der Temperaturdifferenz zwischen dem Eingang und dem Ausgang der Leitung läßt sich unmittelbar auf die Größe des Massenstroms schließen. Der Meßwert wird mit einem Sollwert verglichen, und der Vergleichswert dient zur Ansteuerung eines Magnetventils, das aus einer Düse und einer dieser vorgelagerten Prallplatte besteht, deren Abstand von der Düse durch ein Sollinoid gesteuert wird. Auf diese Weise läßt sich der Massenstrom äußerst genau einregeln und auch gezielt verstellen. Der Massenstrom kann dabei zwischen 0,1 und 30 g/Stunde bei einer linearen Kennlinie mit einer maximalen Abweichung von ± 0,83% eingestellt werden.

Es ist dabei besonders vorteilhaft, wenn man dem die Kapillarwirkung aufweisenden Körper die Verdampfungswärme zumindest überwiegend durch Strahlungsbeheizung zuführt.

Auf diese Weise berührt das flüssige Monomer jedenfalls nicht die beheizten Wände des Verdampfers, so daß es auch nicht zu chemischen Veränderungen des Monomeren kommt.

Es ist dabei weiterhin von Vorteil, wenn man den die Kapillarwirkung aufweisenden Körper langgestreckt ausbildet und an seinen Enden frei aufhängt und wenn man das flüssige Monomer dem einen Ende des Körpers zuführt und das verdampfte Monomer von der freien Oberfläche des Oberkörpers abzieht und der Reaktionszone in einer Vakuumkammer zuführt.

Es ist weiterhin von Vorteil, wenn man in dem die Kapillarwirkung aufweisenden Körper von der Eintrittsseite des flüssigen Monomers bis zur Austrittsseite des dampfförmigen Monomers einen Temperaturgradienten mit positivem Vorzeichen erzeugt.

Die Erfindung bezieht sich außerdem auch auf eine Vorrichtung zur Durchführung des eingangs beschriebenen Verfahrens mit einer Strömungs-Stelleinrichtung und einem dieser nachgeschalteten Verdampfer, der eine Verdampferkammer mit einem Eintrittsende und einem Austrittsende und eine zur Beheizung dienende Heizeinrichtung aufweist und dem eine Vakuumkammer für die Durchführung eines chemischen Dampfabscheidungsprozesses nachgeschaltet ist.

Zur Lösung im wesentlichen der gleichen Aufgabe ist eine solche Vorrichtung erfindungsgemäß dadurch gekennzeichnet, daß die Strömungs-Stelleinrichtung ein Massendurchflußregler ist und daß in der Verdampferkammer ein eine Kapillarwirkung aufweisender Körper angeordnet ist, dessen eines Ende mit einer vom Massendurchflußregler kommenden Zuleitung verbunden ist und der im Abstand von den beheizten Wänden der Verdampferkammer, aber in Sichtverbindung mit diesen gehalten ist.

Von besonderer Bedeutung ist hierbei der die Kapillarwirkung aufweisende Körper. Es kann sich dabei um ein poröses keramisches und/oder mineralisches Material handeln, um ein Vlies, ein Gewebe oder einen Strang (Rundschnur) aus einem faserigen anorganischen oder organischen Material etc. Die Porengröße bzw. der Abstand zwischen den einzelnen Fasern bestimmt dabei den Umfang der Kapillarwirkung. Man kann derartige Körper auch als "schwammartig" bezeichnen.

Es ist dabei ganz besonders zweckmäßig, wenn das eintrittsseitige Ende des die Kapillarwirkung aufweisenden Körpers in die Zuleitung für das flüssige Monomer eingesetzt ist und wenn die Längsachse des Körpers unter einem spitzen Winkel nach unten geneigt zu der besagten Kammerachse verläuft. Auf diese Weise tritt das flüssige Monomer an einem Ende in das saugfähige Material ein und wandert unter laufendem Verdampfen von Teilvolumina in Richtung auf das austrittsseitige Ende des die Kapillarwirkung aufweisenden Körpers. Die Auslegung wird dabei so getroffen, daß keine Flüssigkeit das austrittsseitige Ende erreicht, so daß das gesamte flüssige Monomere im Bereich des genannten Körpers von der flüssigen in die Dampfphase umgewandelt wird.

Weitere vorteilhafte Ausgestaltungen ergeben sich aus den übrigen Unteransprüchen.

Ein Ausführungsbeispiel des Erfindungsgegenstandes wird nachfolgend anhand der Figuren 1 bis 5 näher erläutert.

Es zeigen :

Figur 1 eine Prinzipdarstellung einer vollständigen Anlage für die Durchführung eines CVD-Verfahrens,

Figur 2 einen Axialschnitt durch einen erfindungsgemäßen Verdampfer

Figur 3 einen Teilausschnitt aus Figur 1 in vergrößertem Maßstab,

Figur 4 ein Diagramm mit 2 Kurven, die den Druckverlauf im Verdampfer und im Rezipienten vom Anfahren bis zum stationären Betrieb zeigen,

Figur 5 ein Auger-Spektrogramm einer Schicht, die nach dem erfindungsgemäßen Verfahren in einer Vorrichtung nach den Figuren 1-3 hergestellt wurde.

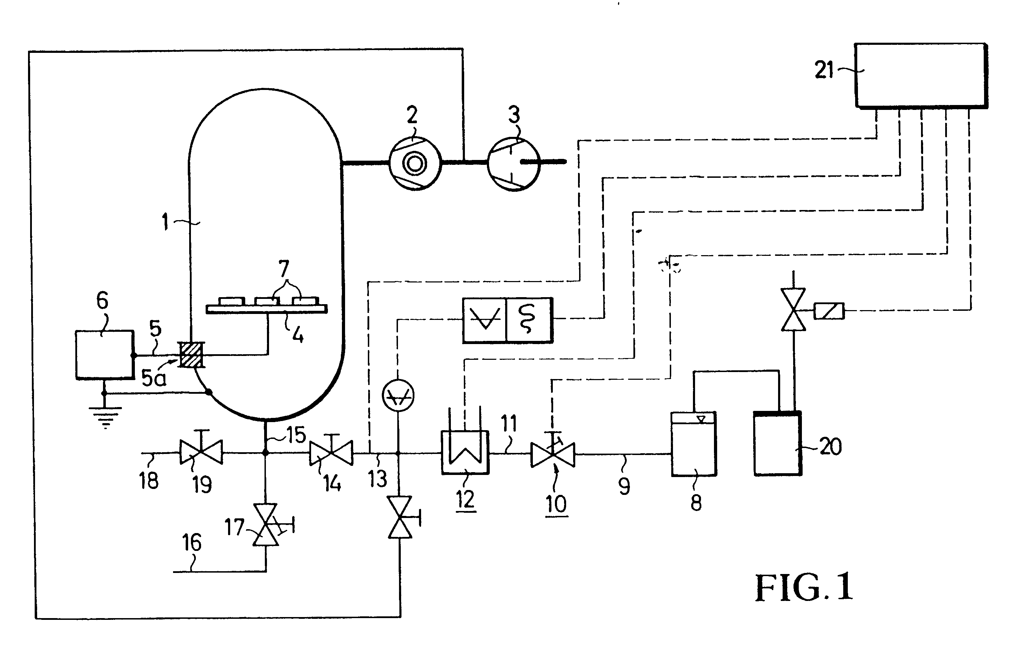

Figur 1 zeigt eine Vakuumkammer 1, in der ein CVD-Prozess durchgeführt wird und die an zwei Vakuumpumpen 2 und 3 angeschlossen ist. In der Vakuumkammer 1 befindet sich ein Substratträger 4, der über eine Leitung 5 an einen Hochfrequenzgenerator 6 angeschlossen ist. Die Vakuumkammer 1 befindet sich auf Massepotential, und die Leitung 5 ist mittels einer Isolierdurchführung 6 durch die Kammerwand hindurchgeführt. Auf dem Substratträger 4 befinden sich mehrere Substrate 7, die durch das CVD-Verfahren beschichtet werden sollen.

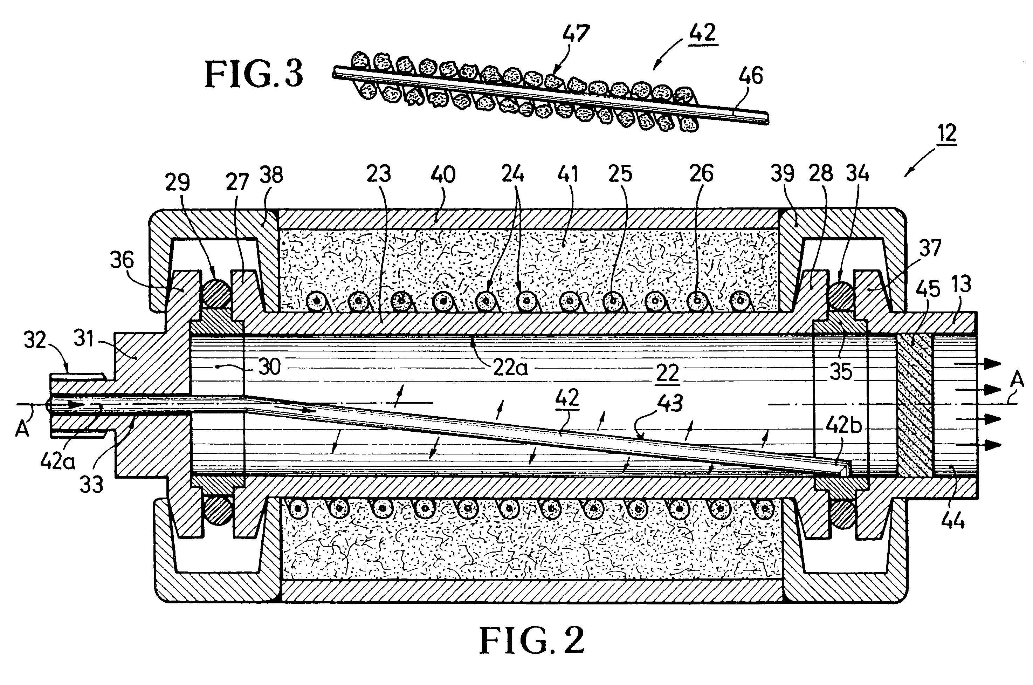

In einem Quellenbehälter 8 befindet sich das flüssige Monomere, das über eine Leitung 9 dem Massendurchflußregler 10 zugeführt wird. Von diesem führt wiederum eine Flüssigkeitsleitung 11 zu einem Verdampfer 12, der nachfolgend anhand der Figuren 2 und 3 noch näher erläutert wird. Vom Verdampfer 12 führt eine Dampfleitung 13 über ein Absperrventil 14 und eine weitere Leitung 15 zur Vakuumkammer 1. Ein Inertgas, mit dem in der Vakuumkammer 1 im Bereich des Substratträgers 4 eine Glimmentladung aufrechterhalten werden kann, wird durch eine Leitung 16 und ein Regelventil 17 in die Leitung 15 eingespeist, während über eine weitere Leitung 18 und ein Stellventil 19 weitere Dotier- und Zusatzgase in die Vakuumkammer 1 eingeleitet werden können. Dem Quellenbehälter 8 ist ein Lufttrockner 20 vorgeschaltet.

Die gesamte Anordnung wird durch eine Steuerungseinheit 21 zentral gesteuert, die über zahlreiche, gestrichelt dargestellte, Leitungen mit den einzelnen Aggregaten verbunden ist. Da mit Ausnahme des Massendurchflußreglers 10 und des Verdampfers 12 die Anordnung gemäß Figur 1 zum Stande der Technik gehört, dürfte ein weiteres Eingehen auf die Wirkungsweise entbehrlich sein.

Der Verdampfer 12 nach Figur 2 besitzt eine Verdampferkammer 22, deren wesentlicher Teil von einem Hohlzylinder 23 gebildet wird, der von einer Heizwicklung 24 umgeben ist. Diese Heizwicklung besteht aus einem zentralen Heizleiter 25 und einer diesen umgebenden Isolierstoffhülle 26 ; die Anschlußenden sind hier nicht weiter gezeigt.

Der Hohlzylinder 23 ist an seinen beiden Enden mit Ringflanschen 27 und 28 versehen. An den auf der Eintrittsseite liegenden Ringflansch 27 ist unter Zwischenschaltung eines Dichtungsringes 29 und eines Zentrierringes 30 eine Stirnwand 31 angesetzt. Diese Stirnwand 31 besitzt einen Gewindestutzen 32, an den die Flüssigkeitsleitung 11 (Figur 1) angeschlossen wird. Im Innern der Stirnwand 31 befindet sich eine Zuleitung 33 für das flüssige Monomere.

An den am Ausgangsende liegenden Ringflansch 28 ist über einen Dichtungsring 34 und einen Zentrierring 35 die Dampfleitung 13 (Figur 1) angeschlossen. Die Stirnwand 31 und die Dampfleitung 13 besitzen zu den Ringflanschen 27 und 28 komplementäre Ringflansche 36 und 37. Die Außenseiten der Ringflanschpaare 27/36 und 28/37 sind kegelförmig ausgebildet, so daß die Ringflansche durch aufgesetzte, halbschalenförmige Klemmringe 38 und 39 gegeneinander verspannbar sind.

Die zwischen den Klemmringen 38 und 39 liegende Heizwicklung 24 ist von einem Außenmantel 40 umgeben. Der Zwischenraum zwischen dem Außenmantel und dem Hohlzylinder 23 ist mit einem Wärmedämmstoff 41 ausgefüllt.

In der Verdampferkammer 22 befindet sich ein langgestreckter, eine Kapillarwirkung aufweisender Körper 42, dessen eines Ende 42a mit der vom Massendurchflußregler kommenden Zuleitung 33 verbunden ist, d.h. das Ende ist in diese Zuleitung eingesetzt. Die Verdampferkammer 22 besitzt eine beheizte Wandfläche 22a, und es ist erkennbar, daß der Körper 42 in Sichtverbindung mit dieser Wandfläche steht, ohne sie aber zu berühren. Vielmehr verläuft die Längsachse des Körpers 42 unter einem spitzen Winkel nach unten geneigt zur Kammerachse A-A. Das andere Ende 42b des Körpers 42 stützt sich auf dem dort befindlichen Zentrierring 35 ab. Durch die spitzwinklige Neigung des Körpers 42 kann das in die Zuleitung 33 eingeführte flüssige Monomere leichter den Körper 42 bergab durchdringen, wobei von der gesamten Oberfläche dieses Körpers das verdampfte Monomere in Richtung der Pfeile austritt.

Es ergibt sich aus Figur 2, daß dem die Kapillarwirkung aufweisenden Körper 42 die Verdampfungswärme nahezu ausschließlich durch Strahlungsbeheizung von der Wandfläche 22a her zugeführt wird.

Figur 2 ist weiterhin zu entnehmen, daß auf der Austrittsseite 44 der Verdampferkammer 22 ein beheizbares Filter 45 angeordnet ist. Dieses Filter dient dazu, sich etwa von dem Körper 42 ablösende Oberflächenpartikel an einem Eintritt in die Vakuumkammer 1 zu hindern. Durch die Beheizung wird dafür Sorge getragen, daß im Filter selbst keine Monomerdämpfe kondensieren können.

Wie sich aus Figur 3 ergibt, besteht der die Kapillarwirkung aufweisende Körper 42 aus einem langgestreckten Tragstab 46, auf den das strangförmige Dochtmaterial 47 schraubenlinienförmig aufgewickelt ist. Anstelle dieses strangförmigen Dochtmaterials kann auch ein schlauch- oder strumpfförmiger Docht verwendet werden, der auf den Tragstab 46 aufgeschoben wird.

Bei dem Gegenstand von Figur 2 nimmt die Flüssigkeitskonzentration von links nach rechts ab und die Dampfkonzentration von links nach rechts zu, während die Temperatur von links nach rechts zunimmt.

Es konnte beobachtet werden, daß die exakt dosierte Flüssigkeit absolut stoßfrei und kontrolliert verdampft und an der Oberfläche 43 austritt.

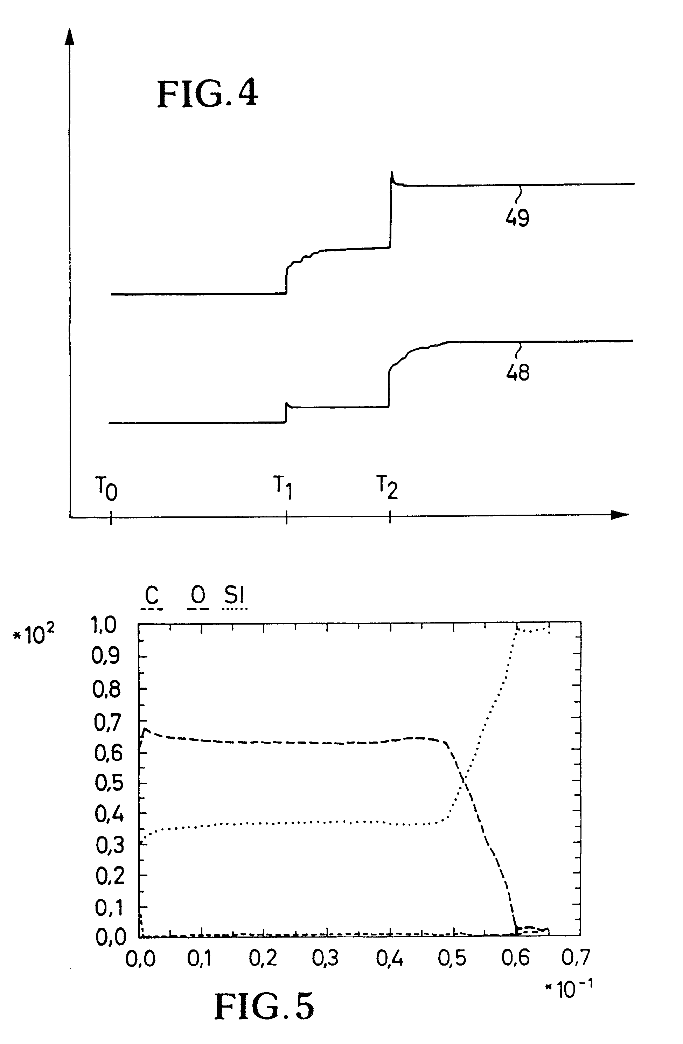

In Figur 4 symbolisiert die Abzisse die Zeitachse und die Ordinate den Druck. Zum Zeitpunkt $T_0$ beginnt das Abpumpen der Vakuumkammer und damit das Evakuieren des gesamten Systems. Zum Zeitpunkt $T_1$ setzt der Betrieb des Verdampfers 12 ein, und ab dem Zeitpunkt $T_2$ gehen die Druckverläufe in einen stationären Betrieb über. Die untere Kurve 48 zeigt den Druckverlauf in der Vakuumkammer 1, während die obere Kurve 49 den Druckverlauf im Verdampfer 12 zeigt. Es ist zu erkennen, daß diese Drücke bei stationärem Betrieb einen sehr konstanten und geradlinigen Verlauf haben.

In Figur 5 symbolisiert der linke Rand des Diagramms die Oberfläche der Schicht auf dem Substrat. Ausgehend von dieser Oberfläche wurde eine Auger-Elektronen-Ionenstrahl-Analyse durchgeführt. Die bis -zum Bereich von etwa 0,5 sehr geradlinigen und waagrechten Verläufe der Konzentrationskurven für Silizium und Sauerstoff zeigen, mit welcher Präzision der Schichtaufbau durchgeführt werden konnte. Dies ist auf die sehr präzise Regelung der verdampften Monomermenge zurückzuführen.

Zur Anwendungsbreite des erfindungsgemäßen Verfahrens ist auszuführen, daß hierdurch bevorzugt $SiO_2$-Schichten für mikroelektronische Anwendungen erzeugt werden, ausgehend von TEOS.

Die in Figur 1 gezeigte Vakuumkammer ist eine Anlage des Typs Z 550 der Firma Leybold AG, bei der der Substratträger 4 mit einer Frequenz von 13,65 MHz beaufschlagt wird. Bei den Substraten handelte es sich um Siliziumscheiben mit einem Durchmesser von 100 mm, auf denen senkrechte Aluminium-Teststufen mit einer Höhe von 750 nm mit einem Stufenabstand von ca. 2 µm angeordnet waren. Das CVD-Verfahren wurde – nach einer entsprechenden Vorbehandlung der Substrate – bei einem Arbeitsdruck von $2 \times 10^{-2}$ mbar durchgeführt, wobei die zugeführte Menge an TEOS 10 g/h betrug. Dabei erfolgte eine Sauerstoffzumischung von 100 sccm. Der Verdampfer 12 wurde auf einer Temperatur von 150°C gehalten; die Substrattemperatur lag bei 100°C. Die Beschichtungsdauer betrug 15 min.

## Ansprüche

1. Verfahren zum Verdampfen von bei Raumtemperatur flüssigen, einen niedrigen Dampfdruck aufweisenden Monomeren, insbesondere solchen aus der Gruppe TEOS (Tetraethylorthosilikat), TMS (Tetramethylsilan) und HMDS (Hexamethyldisiloxan), bei der Herstellung von Silizium und Sauerstoff enthaltenden dünnen Schichten durch chemische Dampfabscheidung (CVD-Verfahren) im Vakuum auf Substraten unter Verwendung einer Strömungs-Stelleinrichtung und eines ihr nachgeschalteten Verdampfers, dadurch gekennzeichnet, daß man als Strömungs-Stelleinrichtung einen Massendurchflußregler verwendet und das von diesem geförderte Monomer in flüssigem Zustand dem Verdampfer zuführt, in dem die restlose Verdampfung beim Druck des Vakuums in einem beheizten, eine Kapillarwirkung aufweisenden Körper herbeigeführt wird.

2. Verfahren nach Anspruch 1, dadurch gekennzeichnet, daß man dem die Kapillarwirkung aufweisenden Körper die Verdampfungswärme zumindest überwiegend durch Strahlungsbeheizung zuführt.

3. Verfahren nach Anspruch 1, dadurch gekennzeichnet, daß man den die Kapillarwirkung aufweisenden Körper langgestreckt ausbildet und an seinen Enden frei aufhängt und daß man das flüssige Monomer dem einen Ende des Körpers zuführt und das verdampfte Monomer von der freien Oberfläche des Körpers abzieht und der Reaktionszone in einer Vakuumkammer zuführt.

4. Verfahren nach Anspruch 3, dadurch gekennzeichnet, daß man in dem die Kapillarwirkung aufweisenden Körper von der Eintrittsseite des flüssigen Monomers bis zur Austrittsseite des dampfförmigen Monomers einen Temperaturgradienten mit positivem Vorzeichen erzeugt.

5. Vorrichtung zur Durchführung des Verfahrens nach Anspruch 1 mit einer Strömungs-Stelleinrichtung und einem dieser nachgeschalteten Verdampfer, der eine Verdampferkammer mit einem Eintrittsende und einem Austrittsende und eine zur Beheizung dienende Heizeinrichtung aufweist, und dem eine Vakuumkammer für die Durchführung eines chemischen Dampfabscheidungsprozesses nachgeschaltet ist, dadurch gekennzeichnet, daß die Strömungs-Stelleinrichtung ein Massendurchflußregler (10) ist und daß in der Verdampferkammer (22) ein eine Kapillarwirkung aufweisender Körper (42) angeordnet ist, dessen eines Ende (42a) mit einer vom Massendurchflußregler kommenden Zuleitung (33) verbunden ist und der im Abstand von der beheizte Wandfläche (12a) der Verdampferkammer (22), aber in Sichtverbindung mit dieser, gehalten ist.

6. Vorrichtung nach Anspruch 4, dadurch gekennzeichnet, daß die Verdampferkammer (22) als ein von der Heizeinrichtung (24) umgebener Hohlzylinder (23) mit einer eintrittsseitigen Stirnwand (31) ausgebildet ist, in die die Zuleitung (33) für das flüssige Monomer mündet, und daß in dem Hohlzylinder der die Kapillarwirkung aufweisende Körper (42) in der Weise angeordnet ist, daß dessen eines Ende (42a) der Zuleitung (33) für das Monomer zugekehrt ist und daß dessen freie Oberfläche (43) der beheizten Wandfläche (22a) der Verdampferkammer zugekehrt ist.

7. Vorrichtung nach Anspruch 6, dadurch gekennzeichnet, daß das eintrittsseitige Ende (42a) des die Kapillarwirkung aufweisenden Körpers (42) in die Zuleitung (33) für das flüssige Monomer eingesetzt ist und daß die Längsachse des Körpers (42) unter einem spitzen Winkel nach unten geneigt zu der Kammerlängsachse (A-A) verläuft.

8. Vorrichtung nach Anspruch 5, dadurch gekennzeichnet, daß der die Kapillarwirkung aufweisende Körper (42) aus einem Dochtmaterial (47) besteht.

9. Vorrichtung nach Anspruch 8, dadurch gekennzeichnet, daß der die Kapillarwirkung aufweisende Körper (42) aus einem langgestreckten Tragstab (46) besteht, der von dem strangförmigen Dochtmaterial (47) umgeben ist.

10. Vorrichtung nach Anspruch 9, dadurch gekennzeichnet, daß das Dochtmaterial (47) auf den Tragstab (46) aufgewikkelt ist.

11. Vorrichtung nach Anspruch 5, dadurch gekennzeichnet, daß auf der Austritsseite (44) der Verdampferkammer (22) ein beheizbares Filter (45) angeordnet ist.

## Claims

1. Process for vaporising monomers which are liquid at room temperature and have a low vapour pressure, in particular those from the group TEOS (tetraethyl orthosilicate), TMS (tetramethylsilane) and HMDS (hexamethyldisiloxane) in the manufacture of thin layers containing silicon and oxygen by chemical vapour deposition (CVD process) on substrates in a vacuum, using a flow control device and a vaporiser connected in series thereto, characterised in that, as a flow control device, a mass flow regulator is used, and the monomer conveyed thereby is fed in the liquid state to the vaporiser, in which the monomer is vaporised without residue at the pressure of a vacuum in a heated body having a capillary action.

2. Process according to claim 1, characterised in that the heat for vaporisation is supplied to the body having a capillary action at least substantially by radiant heating.

3. Process according to claim 1, characterised in that the body having a capillary action is elongate and is suspended freely at its ends, and in that the liquid monomer is fed to one end of the body and the vaporised monomer is extracted from the free surface of the body and is supplied to the reaction zone in a vacuum chamber.

4. Process according to claim 3, characterised in that a temperature gradient with a positive sign is generated in the body having a capillary action from the inlet side of the liquid monomer to the outlet side of the vaporised monomer.

5. Apparatus for carrying out the process according to claim 1, having a flow control device and a vaporiser connected in series thereto, which has a vaporising chamber with an inlet end and an outlet end and a heating device for heating, and to which a vacuum chamber for carrying out a chemical vapour deposition process is connected in series, characterised in that the flow control device is a mass flow regulator (10) and in that, in the vaporising chamber (22), a body (42) having a capillary action is mounted, whose one end (42a) is connected to a supply line (33) from the mass flow regulator, the body being held at a distance from the heated wall face (12a) of the vaporising chamber (22), but in visual contact therewith.

6. Apparatus according to claim 4, characterised in that the vaporising chamber (22) is formed as a hollow cylinder (23) surrounded by the heating device (24) and provided with an inlet-side end wall (31), into which the supply line (33) for the liquid monomer opens, and in that the body (42) having a capillary action is so mounted in the hollow cylinder that its one end (42a) faces the supply line (33) for the monomer and in that its free surface (43) faces the heated wall face (22a) of the vaporising chamber.

7. Apparatus according to claim 6, characterised in that the inlet-side end (42a) of the body (42) having a capillary action is inserted into the supply line (33) for the liquid monomer, and in that the longitudinal axis of the body (42) is inclined downwards at an acute angle to the longitudinal axis (A-A) of the chamber.

8. Apparatus according to claim 5, characterised in that the body (42) having a capillary action consists of a wick material (47).

9. Apparatus according to claim 8, characterised in that the body (42) having a capillary action consists of an elongate carrying rod (46), which is surrounded by the cordlike wick material (47).

10. Apparatus according to claim 9, characterised in that the wick material (47) is wound on the carrying rod (46).

11. Apparatus according to claim 5, characterised in that a heatable filter (45) is mounted on the outlet side (44) of the vaporising chamber (22).

## Revendications

1. Procédé de vaporisation de monomères liquides à la température ambiante, présentant une tension de vapeur basse, notamment ceux du groupe TEOS (tétraéthylorthosilicate), TMS (tétraméthylsilane) et HMDS (hexaméthyldisiloxane), lors de la fabrication de couches minces contenant du silicium et de l'oxygène par dépôt chimique en phase vapeur (procédé CVD) sous vide sur des substrats utilisant un dispositif de réglage de l'écoulement et un évaporateur situé en aval, caractérisé en ce qu'on utilise comme dispositif de réglage de l'écoulement un régulateur de débit massique et qu'on amène le monomère transporté par ce dernier à l'état liquide à l'évaporateur dans lequel s'effectue l'évaporation intégrale sous la pression du vide, dans un corps chauffé faisant preuve de capillarité.

2. Procédé selon la revendication 1, caractérisé en ce qu'on fournit la chaleur d'évaporation au corps faisant preuve de capillarité au moins principalement par chauffage à rayonnement.

3. Procédé selon la revendication 1, caractérisé en ce qu'on utilise un corps faisant preuve de capillarité étiré en longueur et suspendu librement à ses extrémités et qu'on amène le monomère liquide à l'une des extrémités du corps et qu'on retire le monomère vaporisé de la surface libre du corps et qu'on l'amène à la zone réactionnelle dans une chambre à vide.

4. Procédé selon la revendication 3, caractérisé en ce que l'on crée dans le corps faisant preuve de capillarité un gradient de température à signe positif du côté entrée du monomère liquide au côté sortie du monomère vaporisé.

5. Dispositif de mise en oeuvre du procédé selon la revendication 1, comportant un dispositif de régulation de l'écoulement et un évaporateur placé en aval présentant une chambre d'évaporation possédant une extrémité entrée et une extrémité sortie et un dispositif de chauffage servant au chauffage et en aval duquel est placée une chambre à vide destinée à la mise en oeuvre d'un procédé de dépôt chimique en phase vapeur, caractérisé en ce que le dispositif de régulation de l'écoulement est un régulateur de débit massique (10) et qu'est disposé dans la chambre d'évaporation (22) un corps (42) faisant preuve de capillarité dont une extrémité (42a) est reliée à une conduite d'amenée (33) en provenance du régulateur de débit massique et qui est maintenu à distance de la paroi chauffée (12a) de la chambre d'évaporation (22), mais est en contact visuel avec celle-ci.

6. Dispositif selon la revendication 4, caractérisé en ce que la chambre d'évaporation (22) est constituée par un cylindre creux (23) entouré d'un dispositif de chauffage (24) et possédant une paroi frontale (31) du côté entrée, dans laquelle débouche la conduite d'amenée (33) du monomère liquide et qu'est disposé dans le cylindre creux le corps (42) faisant preuve de capillarité de telle façon que l'une de ses extrémités (42a) est adjacente à la conduite d'amenée (33) du monomère et que sa surface libre (43) est adjacente à la paroi chauffée (22a) de la chambre d'évaporation.

7. Dispositif selon la revendication 6, caractérisé en ce que l'extrémité (42a) du côté entrée du corps (42) faisant preuve de capillarité est introduite dans la conduite d'amenée (33) du monomère liquide et que l'axe longitudinal du corps (42) est incliné vers le bas à angle aigu en direction de l'axe longitudinal (A-A) de la chambre.

8. Dispositif selon la revendication 5, caractérisé en ce que le corps (42) faisant preuve de capillarité est en un matériau à mèche (47).

9. Dispositif selon la revendication 8, caractérisé en ce que le corps (42) faisant preuve de capillarité est constitué par une baguette porteuse (46) étirée en longueur, entourée du matériau à mèche (47) en forme de cordon.

10. Dispositif selon la revendication 9, caractérisé en ce que le matériau à mèche (47) est enroulé sur la baguette porteuse (46).

11. Dispositif selon la revendication 5, caractérisé en ce qu'est disposé un filtre (45) chauffable du côté sortie (44) de la chambre d'évaporation (22).

FIG.1

EP 0 361 171 B1

FIG.3

FIG.2

**FIG.4**

**FIG.5**